# EUROPEAN PATENT APPLICATION

(11) **EP 0 871 231 A2**
(43) Date of publication of application: **14.10.1998**
(21) Application number: 98302429.0
(22) Date of filing: 30.03.1998
(51) Int. Cl.: H01L 43/08, G01R 33/09, G11B 5/39

(54) **Magnetoresistive element**

(30) Priority: 10.04.1997 JP 92565/97
(71) Applicant: ALPS ELECTRIC CO., LTD., Ota-ku Tokyo 145 (JP)
(72) Inventor: Umetsu, Eiji, 3-1-30, Jooka, Nagaoka-shi, Niigata-ken (JP); Hasegawa, Naoya, Nagaoka-shi, Niigata-ken (JP); Makino, Akihiro, Nagaoka-shi, Niigata-ken (JP)
(74) Representative: Kensett, John Hinton

(57) **Abstract**

The present invention provides a magnetoresistive element comprising at least one layer of a pinned ferromagnetic layer in which inversion of magnetization is pinned, at least one free layer of a free ferromagnetic layer magnetization of which freely rotates against the external magnetic field and an auxiliary magnetization reversing layer positioned in adjoining or closely spaced relation to the free ferromagnetic layer to assist inversion of magnetization and having a soft magnetic characteristic, thereby enabling to lower the coercive force of the free ferromagnetic layer.

## Description

The present invention relates to a magnetoresistive element constituting a magnetoresistive element used for magnetic heads, positioning sensors, rotation sensors and the like.

Conventional magnetoresistive reading heads (MR head) comprise AMR (Anisotropic Magnetoresistance) heads utilizing an anisotropic megnetoresistance phenomenon and GMR (Giant Magnetoresistance) heads utilizing a spin depending scattering phenomenon of conductive electrons, a spin-valve head that exhibit a high magnetoresistive effect at low external magnetic field being disclosed in the specification of US patent publication No. 5,159,513 as one example of GMR heads.

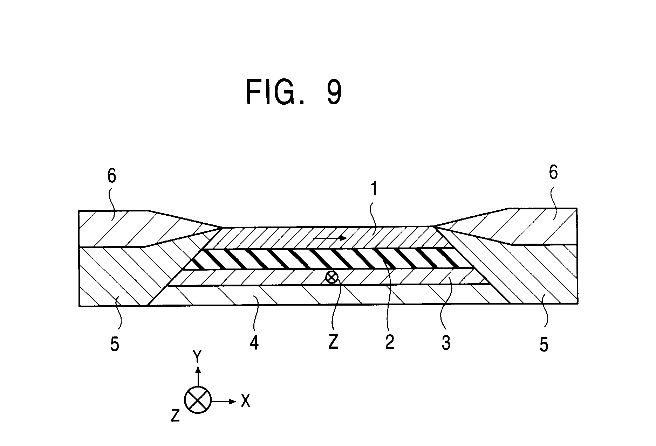

Fig. 9 is one example of the conventional spin-valve structure, which is constructed by laminating a free ferromagnetic layer **1**, a nonmagnetic intermediate layer **2**, a pinned ferromagnetic layer **3** and an antiferromagnetic layer **4** on a substrate, providing two magnet layers **5**, **5** comprising Co-Pt and the like at both sides of this laminated member so as to insert the laminated member between the magnet layers, on which two electrode layers **6**, **6** are provided.

In the conventional structure shown in Fig. 9, a relatively large bias magnetic field is needed to fix the direction of magnetization of the pinned ferromagnetic layer **3** along the z-direction in Fig. 9, a larger vias magnetic field being preferable. A vias magnetic field of at least 100 Oe is required in order to overcome an antimagnetic field along the z-direction in Fig. 9 thereby preventing the direction of magnetization from being fluctuated due to a magnetic flux from a magnetic medium.

An exchange anisotropic magnetic field generated by providing a pinned ferromagnetic layer **3** in contact with an exchange coupling layer **4** is utilized in the conventional structure shown in Fig. 9 to obtain this vias magnetic field.

In the structure shown in Fig. 9, magnetization should be made to direct toward the track direction as a single magnetic domain by impressing a vertical vias parallel to the film face (X-direction in Fig. 9: the track direction) on the free ferromagnetic layer **1** from the magnet layers **5**, **5**, along with allowing the direction of magnetization of the pinned ferromagnetic layer **3** to direct toward the Z-direction in Fig. 9 as a single magnetic domain by impressing a vias along the Z-direction in Fig. 9, that is, a direction perpendicular to magnetization of the free ferromagnetic layer **1**. The object of impressing a vertical vias is to suppress Barkhausen noise arising from a lot of magnetic domains formed by the free ferromagnetic layer **1** or, in other words, to make resistance against the magnetic flux from a magnetic medium to change smoothly with low noise levels.

The direction of magnetization of the pinned ferromagnetic layer **3** should not be changed by the magnetic flux (along the Z-direction in Fig. 9) from the magnetic medium. Rather, a linear response could be obtained by allowing the direction of the free ferromagnetic layer **1** to change in a range of 90 ± θ° relative to the direction of magnetization.

As described above, a magnetoresistive head having a good linear response in which Barkhausen noise is suppressed can be realized by taking advantage of a vias in the pinned ferromagnetic layer at the spin valve head, and the exchange anisotropic magnetic field generated in the vertical vias of the free ferromagnetic layer at a contact interface with the antiferromagnetic layer.

The exchange anisotropic magnetic field is a phenomenon arising from an exchange interaction between magnetic moments of the ferromagnetic layer and exchange coupling layer at a contact face between the two layers. An well known example of the antiferromagnetic layer that generate an exchange anisotropic magnetic filed with a ferromagnetic layer, for example NiFe layer, is FeMn layer. However, corrosion resistance of FeMn layer is so poor that corrosion is progressed during the manufacturing process of magnetic heads or operation of magnetic heads, thereby largely deteriorating the exchange anisotropic magnetic field. While it is well known that the temperature at the position in closely spaced relation to the FeMn layer is easily increased to about 120 °C due to heat generation by a steady sensing current, the exchange anisotropic magnetic field created by the FeMn layer is so sensitive to temperature changes that the exchange anisotropic magnetic field is approximately linearly reduced against temperature until it has ben quenched at a temperature of about 150 °C (a blocking temperature: Tb). Accordingly, there remains a problem that a stable exchange anisotropic magnetic field is hardly obtainable.

In USP 5,688,380, the inventors of the present invention disclosed a magnetoresistive element provided with a coercive force increasing layer of α-Fe₂O₃ that is able to obtain a giant magnetoresistive effect besides having superior corrosion resistance and temperature characteristics to FeMn, wherein the element makes use of a mechanism in which pinning of rotation of magnetization is possible by increasing the coercive force of the ferromagnetic layer in adjoining relation thereto.

According to this patent application, a pinned ferromagnetic layer is formed by pinning rotation of magnetization of the ferromagnetic layer by disposing a coercive force increasing layer of α-Fe₂O₃ to one of the two ferromagnetic layers laminated via non-magnetic layers while a free magnetic layer is formed by allowing magnetization of the other ferromagnetic layer to be freely rotated, thereby arising a resistance change by making the free ferromagnetic layer to rotate by the external magnetic field. Since the blocking temperature of α-Fe₂O₃ is far more higher than that of FeMn, the magnetoresistive element having the structure described above has an advantage that its magnetic properties are hardly changed by temperature variations, characterized by having no problem in corrosion resistance because α-Fe₂O₃ itself is an oxide.

Since the orientation of magnetization in the free ferromagnetic layer **1** of the free ferromagnetic layer **1** and pinned ferromagnetic layer **3** provided by inserting a non-magnetic layer **2** therebetween should be freely rotated by sensitively responding to the external magnetic field in the magnetoresistive element with a spin valve structure using FeMn, or in the magnetoresistive element provided with a coercive force increasing layer of α-Fe₂O₃, it is preferable that the coercive force is small. On the contrary, the orientation of the pinned ferromagnetic layer **3** should not be made to move by responding to the external magnetic field.

In the structure in which the free ferromagnetic layer **1** and pinned ferromagnetic layer **3** are laminated via the non-magnetic layer **2**, on the other hand, the coercive force of the free ferromagnetic layer **1** is increased higher than the inherent level of the material due to the effect of the magnetic field created by the pinned ferromagnetic layer **3**, hindering free rotation of magnetization of the free ferromagnetic layer **1**, so that characteristics of R - H curves as a magnetoresistive element may be possibly deteriorated.

The object of the present invention, which is carried out by taking the above situations into account, is to provide a magnetoresistive element being made easy to reverse magnetization as a result of low coercive force of the free ferromagnetic layer by providing with an auxiliary magnetization reversing layer and exhibiting a magnetoresistive effect sensitively responding to the external magnetic field, wherein the magnetoresistive effect can be prevented from being decreased by depressing the electric current that tends to be branched into the auxiliary magnetization reversing layer by providing the auxiliary magnetization reversing layer with a material of high resistivity.

For solving the hitherto described problems, the present invention is characterized by being provided with at least one pinned ferromagnetic layer in which inversion of magnetization is pinned, at least one free ferromagnetic layer in which magnetization is freely rotated against the external magnetic field, and an auxiliary magnetization reversing layer assisting inversion of magnetization of the ferromagnetic layer by being disposed in adjoining relation or in closely spaced relation to the free ferromagnetic layer and having an auxiliary magnetization reversing layer with soft magnetic characteristics.

It is preferable in the present invention that the auxiliary magnetization reversing layer mainly comprises a fine crystalline phase principally composed of bcc Fe structure and an amorphous phase containing an element M comprising one or a plurality of elements selected from Ti, Zr, Hf, V, Nb, Ta, W and rare earth elements, and O (oxygen).

It is preferable in the present invention that the auxiliary magnetization reversing layer mainly comprises a fine crystalline phase principally composed of bcc Fe structure and a crystalline phase containing carbide and nitride of an element M' comprising one or a plurality of elements selected from Ti, Zr, Hf, V, Nb, Ta, W and rare earth elements.

According to the present invention, the pinned ferromagnetic layer is provided in adjoining relation to an exchange coupling layer so that inversion of magnetization of pinned ferromagnetic layer is pinned in response to the magnetic exchange coupling due to said exchange coupling layer.

The exchange coupling layer may be mainly composed of α-Fe₂O₃ while the exchange coupling layer is mainly composed of a X-Mn alloy, wherein X in the composition formula X-Mn denotes one or a plurality of elements selected from platinum group elements.

It is preferable that the thickness of the auxiliary magnetization reversing layer is in the range of 50 to 300 Å and the specific resistivity of the auxiliary magnetization reversing layer is in the range of 200 to 2 × 10⁵ µΩcm.

### BRIEF DESCRIPTION OF THE DRAWINGS

Fig. 1 is a cross section showing the 1st aspect of the magnetoresistive multilayer film according to the present invention.

Fig. 2 is a cross section showing the 2nd aspect of the magnetoresistive multilayer film according to the present invention.

Fig. 3 is a cross section showing the 3rd aspect of the magnetoresistive multilayer film according to the present invention.

Fig. 4 is a cross section showing the 4th aspect of the magnetoresistive multilayer film according to the present invention.

Fig. 5 is a graph indicating a M-H curve of a sample of the soft magnetic layer (a layer of Fe₆₀Hf₁₀O₃₀) provided on the Si substrate covered with a Al₂O₃ layer.

Fig. 6 shows a R-H curve of the free ferromagnetic layer of the magnetoresistive multilayer film having a laminated construction of Si substrate / Al₂O₃ layer / α-Fe₂O₃ layer / NiFe layer / Cu layer / NiFe layer / Fe₆₀Hf₁₀O₃₀ layer, and a R-H curve of the free ferromagnetic layer of the magnetoresistive multilayer film having a construction in which Fe₆₀Hf₁₀O₃₀ layer is omitted in the foregoing laminated structure.

Fig. 7 shows a R-H curve of the free ferromagnetic layer of the magnetoresistive multilayer film having a laminated construction of Si substrate / Al₂O₃ layer / α-Fe₂O₃ / NiFe layer / Co layer / Cu layer / Co layer / NiFe layer / Fe₆₀Hf₁₀O₃₀ and a R-H curve of the free ferromagnetic layer of the magnetoresistive multilayer film having a construction in which the Fe₆₀Hf₁₀O₃₀ layer is omitted in the foregoing laminated structure.

Fig. 8 shows a R-H curve of the free ferromagnetic layer of the magnetoresistive multilayer film having a laminated construction of Si substrate / Al₂O₃ layer / α-Fe₂O₃ / NiFe layer / CoFe layer / Cu layer / CoFe layer / NiFe layer / Fe₆₀Hf₁₀O₃₀ layer, and R-H curve of the free ferromagnetic layer of the magnetoresistive multilayer film having a construction in which Fe₆₀Hf₁₀O₃₀ layer is omitted in the foregoing laminated structure.

Fig. 9 is a cross section of the 1st aspect of the conventional magnetoresistive sensor.

One embodiment of the present invention will be described hereinafter referring to the drawings, as an example

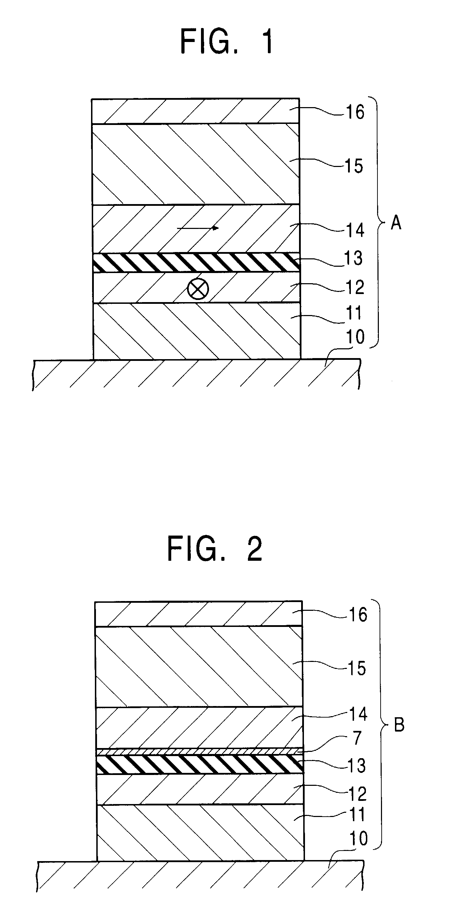

Fig. 1 is an aspect of a magnetoresistive multilayer film provided on the magnetoresistive element according to the present invention, wherein the magnetoresistive multilayer film **A** of this configuration is mainly composed of a substrate **10** of a non-magnetic member, and a pinning thin film layer **11**, a pinned ferromagnetic layer **12**, a non-magnetic layer **13**, a free ferromagnetic layer **14**, an auxiliary magnetization reversing layer **15** and a protective layer **16** each being laminated thereon.

While electrode layers and magnet layers to be used in the construction shown in Fig. 9 are omitted in Fig. 1, it is needless to say that the construction in Fig. 1 is also preferably applicable in the construction shown in Fig. 9 in order to allow resistance to be smoothly changed without any Barkhausen noise by impressing a vertical vias.

The substrate **10** is composed of a non-magnetic material represented by a glass, Si, Al₂O₃, TiC, SiC and a sintered body of Al₂O₃ and TiC. A cover layer and a buffer layer may be appropriately provided on the substrate **10** for the purpose of eliminating roughness of the substrate surface or to make crystalline matching of the layer laminated thereon comfortable.

An exchange coupling layer **11** is provided in order to enhance coercive force of the pinned ferromagnetic layer **12** by allowing a magnetic exchange coupling force to effect on the pinned ferromagnetic layer **12** formed thereon. It is preferable that this exchange coupling layer **11** is composed of an antiferromagnetic material, especially an oxide antiferromagnetic material, an example of which being α-Fe₂O₃. A hard magnetic material may be also used for this exchange coupling layer **11**, an example of it being Co-Pt alloy and the like.

A magnetoresistive multilayer film being excellent in linear response in addition to being robust in temperature changes and securely suppressing Barkhausen noise can be provided if the exchange coupling layer **11** is composed of α-Fe₂O₃ because the Molin point of α-Fe₂O₃ itself is high.

The exchange coupling layer **11** can be also constructed with X-Mn alloy films (wherein X denotes one or a plurality of platinum group elements such as Pt, Pd, Ir, Ru and Rh).

Both of the pinned ferromagnetic layer **12** and free ferromagnetic layer **14** comprise ferromagnetic thin films, examples of them being NiFe alloy, NiCo alloy and NiFeCo alloy. The free ferromagnetic layer **14** and pinned ferromagnetic layer **12** can be composed of a NiFe alloy layers, respectively, or the free ferromagnetic layer **14** may be constructed of a laminated structure of NiFe alloy layers or a laminated structure of CoFe alloy layers and NiFe alloy layers.

When the free ferromagnetic layer **14** is composed of a laminated structure, the layer is preferably made of a magnetoresistive multilayer film B in which a metallic layer **17** such as thin Co layer or CoFe (Co₉₀Fe₁₀) alloy is disposed to the non-magnetic layer **13** as shown in Fig. 2.

The reason of the above description comes from the fact that, with respect to the mechanism for generating a giant magnetoresistive effect arising from the structure in which the non-magnetic layer **13** is inserted between the ferromagnetic layers **12** and **14**, a higher magnetoresistive effect can be obtained owing to a low possibility of arising a disturbing factor other than conductive electron spin depending scattering when the ferromagnetic layers **12** and **14** are composed of the same kind of material rather than composing the layer of different kind materials. From these facts, the structure shown in Fig. 2 in which the non-magnetic layer **13** side of the ferromagnetic layer **14** is replaced with a Co layer of a given thickness is preferable when the pinned ferromagnetic layer **12** is composed of Co. Also, Co may be predominantly contained in the non-magnetic layer **13** side of the ferromagnetic layer **14** to form an alloy, thereby forming a concentration gradient gradually decreasing Co concentration along the direction toward the auxiliary magnetization reversing layer **15**, instead of especially providing a Co layer.

The non-magnetic layer **13** comprises a non-magnetic material represented by Cu, Cr, Au and Ag with a thickness of 20 to 40 Å. When the thickness of the non-magnetic layer **13** is less than 20 Å, the pinned ferromagnetic layer **12** becomes ready to be magnetically coupled with the free ferromagnetic layer **14**. A thickness of more than 40 Å of the non-magnetic layer **13** is not preferable, on the other hand, because the effectiveness of conductive electrons that pass through the interface between the non-magnetic layer **13** and ferromagnetic layers **12** and **14** and arise magnetoresistive effect is decreased, or the magnetoresistive effect is diminished due to electric current branching effect.

The auxiliary magnetization reversing layer **15** comprises a soft magnetic material with small coercive force, large saturation magnetization, large magnetic permeability and large resistivity with a preferable thickness of 100 to 300 Å, examples of them being those having the following composition.

The preferable auxiliary magnetization reversing layer to be used in the present invention mainly composed of a fine crystalline phase principally comprising bcc Fe structure and an amorphous phase containing an element M comprising one or a plurality of elements of Ti, Zr, Hf, V, Nb, Ta, W and rare earth elements, and O (oxygen).

The auxiliary magnetization reversing layer also mainly comprises a fine crystalline phase principally composed of bcc Fe structure and a crystalline phase containing carbides and nitride of an element M comprising one or a plurality of elements selected from Ti, Zr, Hf, V, Nb, Ta, W and rare earth elements.

Examples of the composition of these auxiliary magnetization reversing layer **15** are as follows.

### Example of composition 1

A soft magnetic alloy represented by a composition formula FeₐM_{b}O_{c} can be applied in the present invention, wherein M denotes at least one element of the rare earth elements (Sc and Y belonging to 3A group of the periodic table, or lanthanoids such as La, Ce, Pr, Nd, Pm, Sm, Eu, Gd, Td, Dy, Ho, Er, Tm, Yb and Lu) or a mixture thereof, and the composition ratios a, b and c satisfy, preferably in atomic %, the relations of 50 ≤ a ≤ 70, 5 ≤ b ≤ 30, 10 ≤ c ≤ 30 and a + b + c = 100. The soft magnetic alloys with this composition can be also used for the object of the present invention because they exhibit a high resistivity of the order of 400 to 1000 µΩ·cm as shown in USP 5,573,863 disclosed by the inventors of the present invention.

### Example of composition 2

A soft magnetic alloy represented by a composition formula Fe_{d}M'ₑO_{f} can be applied in the present invention, wherein M' denotes at least one element selected from a group of Ti, Zr, Hf, V, Nb, Ta and W or a mixture thereof, and the composition ratios d, e and f satisfy, preferably in atomic %, the relations of 45 ≤ d ≤ 70, 5 ≤ e ≤ 30, 10 ≤ f ≤ 40 and d + e + f = 100. The soft magnetic alloys with this composition can be used for the object of the present invention because they exhibit a high resistivity of the order of 400 to 2.0 × 10⁵ uΩ·cm as shown in USP 5,573,863 disclosed by the inventors of the present invention.

### Example of composition 3

The composition formula is represented by T_{100 - a' - b' -} _{c' - d'}M'_{b'} -Z_{c'} -Q_{d'}, wherein T represents any one or both of Fe and Co, X represents any one or both of Si and Al, M' represents at least one element selected from a group of Ti, Zr, Hf, V, Nb, Ta, Mo and W, Z represents any one or both of C and N, and Q represents at least one element selected from a group of Cr, Re, Ru, Rh, Ni, Pd, Pt and Au.

It is preferable that the foregoing composition satisfies the following composition ratio (atomic 5): 0 ≤ a' ≤ 25, 1 ≤ b' ≤ 7, and 0.5 ≤ c' ≤ 10.

The soft magnetic alloys with this composition can be used for the object of the present invention because they exhibit a high saturation magnetization density of more than 1T.

### Example of composition 4

The composition formula is represented by T_{100 - e' - f' -} _{b' - c' - d'}Al_{f'}M'_{b'} -Z_{c'} -Q_{d'}, wherein T represents any one or both of Fe and Co, M' represents at least one element selected from a group of Ti, Zr, Hf, V, Nb, Ta, Mo and W, Z represents any one or both of C and N, and Q represents at least one element selected from a group of Cr, Re, Ru, Rh, Ni, Pd, Pt and Au. It is preferable that the foregoing composition satisfies the following composition ratio (atomic %): 8 ≤ e' ≤ 15, 0.5 ≤ f' ≤ 10, 1 ≤ b' ≤ 7, 0.5 ≤ c' ≤ 10 and 0 ≤ d' ≤ 10.

The soft magnetic alloys with this composition can be used for the object of the present invention because they exhibit a high saturation magnetization density of more than 1T.

### Example of composition 5

The composition formula is represented by (Co₁₋ _{g}T_{g})_{x'}M_{y}Q_{z}X_{w}Yₛ, wherein T represents one or a plurality of elements selected from a group of Fe, Ni, Pd, Mn and Al, M represents at least one element selected from a group of Ti, Zr, Hf, Nb, Ta, M and Y, and one or a plurality of elements selected from rare earth elements, Q represents one or a plurality of elements selected from 0, N and B, X represents one or both of Si and Cr, and Y represents one or both of Au and Ag. In the formula, g satisfies the relation of 0.05 ≤ g ≤ 0.5 while y, z and w satisfy the relations of 3 ≤ y ≤ 30, 7 ≤ z ≤ 40, 0 ≤ w ≤ 20 and 0 ≤ s ≤ 20, respectively in atomic %, with a balance of inevitable impurities.

Through the protective layer **16** is provided for protecting the auxiliary magnetization reversing layer **15**, the former layer can be omitted. An insulating overcoat layer may be also provided on this protective layer **16**. It is preferable that the overcoat layer provided is composed of an insulating material such as Al₂O₃ and quartz.

In the construction shown in Fig. 1, a steady current is imparted to the magnetoresistive multilayer film A.

When the construction shown in Fig. 1 is provided, the orientation of magnetization in the pinned ferromagnetic layer **12** is pinned and the orientation of magnetization in the ferromagnetic layer **14** is made free in the area corresponding to the track width, so that a coercive force difference between the ferromagnetic layers **12** and **14** is created, thereby arising a giant magnetoresistive effect. That is to say, when an external magnetic field such as leakage magnetic field from a magnetic recording medium operates on the free ferromagnetic layer **14** whose rotation of magnetization has been made free, the orientation of magnetization of the free ferromagnetic layer **14** is easily rotated and a resistance change in the multilayer film with magnetoresistive effect is caused accompanied by the rotation, so that magnetic information recorded on the magnetic medium can be read.

Since an auxiliary magnetization reversing layer **15** having a large saturation magnetization and specific resistivity, and a small coercive force is provided on the free ferromagnetic layer **14** in the construction as described previously, the free ferromagnetic layer **14** can be coupled with the auxiliary magnetization reversing layer **15**, thereby making it possible to reduce coercive force of the free ferromagnetic layer **14**. The auxiliary magnetization reversing layer **15** is able to sensitively respond to the external magnetic field owing to its small coercive force besides magnetization of the free ferromagnetic layer **14** making a contact with the auxiliary magnetization reversing layer **15** is readily rotated since its saturation magnetization is large. Consequently, the magnetoresistive effect can be displayed with a good lineality. Since the auxiliary magnetization reversing layer **15** itself has a high specific resistivity, branching electric current being liable to flow through the auxiliary magnetization reversing layer **15** can be reduced, consequently increasing the proportion of current that flow through the interface between the non-magnetic layer **13** and ferromagnetic layers **12** and **14** to lower the reduced proportion of the magnetoresistive effect.

Since Cu and elements in the Ni-Fe alloy are ready to diffuse in the interface by a heat treatment in the construction in which the free ferromagnetic layer **14** comprising a Ni-Fe alloy (permalloy) is directly laminated on the non-magnetic layer **13** comprising Cu, heat resistance of the layer can be improved by providing a metallic layer **17** comprising Co or CoFe as shown in Fig. 2. The construction shown in Fig. 2 is preferable because the structure in which Co makes a contact with the non-magnetic layer exhibits a large magnetoresistive effect in the mechanism for generating magnetoresistive effect in which a non-magnetic layer of Cu is inserted into the ferromagnetic layers. However, since the metallic layer **17** tends to increase coercive force in the free ferromagnetic layer **14** in the construction shown in Fig. 2, the auxiliary magnetization reversing layer **15** provided on the free ferromagnetic layer **14** is effective because the former suppresses increase of the coercive force in the free ferromagnetic layer **14**. Accordingly, the construction shown in Fig. 2 makes it possible to obtain a magnetoresistive multilayer film having a good heat resistance and large magnetoresistive effect besides allowing resistivity to change sensitively responding to the external magnetic field.

The exchange coupling layer **11** in the structure shown in Fig. 1 may be composed of α-Fe₂O₃, an oxide by itself, having a superior corrosion resistance to FeMn that is used in the conventional spin valve structure besides being characterized by its toughness to temperature variations due to its high Neel temperature.

The result of calculation of a sense current, a branch current fraction of the current that flows through the auxiliary magnetization reversing layer of the magnetoresistive multilayer film, is described below, wherein it is assumed that a coercive force increasing layer of α-Fe₂O₃ with a thickness of 1000 Å, a pinned ferromagnetic layer of NiFe alloy with a thickness of 58 Å, a non-magnetic layer of Cu with a thickness of 22 Å and a free ferromagnetic layer of NiFe alloy with a thickness of 87 Å are laminated on the substrate and FeHfO films with a thickness of 50 Å, 100 Å and 200 Å, respectively, are formed thereon in the multilayer film **A** with a magnetoresistive effect.

Let the resistance of the spin valve structure portion comprising a pinned ferromagnetic layer, non-magnetic layer and free magnetic layer be Rₛᵥ, the electric current flowing therethrough be iₛᵥ, the resistance of a auxiliary magnetization reversing layer be R_{OL} and the electric current flowing therethrough be i_{OL}. When a film with a composition of FeHfO (saturation magnetization Is = 1.4T, specific resistivity ρ = 380 µΩ·cm, coercive force Hc = 0.4 Oe and magnetic permeability µ' at 100 MHz = 1500) is used for the auxiliary magnetization reversing layer, i_{OL}'s can be calculated as 0.0089 i, 0.0177 i, 0.0348 i and 0.0514 i when the layer film thickness of the auxiliary magnetization reversing layers are 50 Å, 100 Å, 200 Å and 300 Å, respectively.

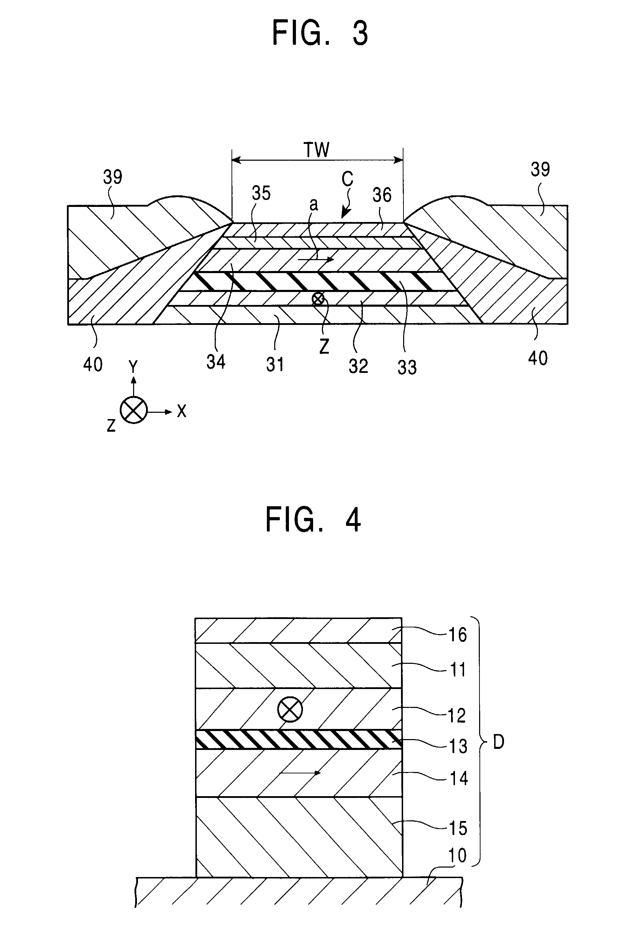

As shown Fig. 3, a magnetoresistive multilayer film **C**, for example with a trapezoidal cross section, is formed by laminating a pinned ferromagnetic layer **32**, a non-magnetic layer **33**, a free ferromagnetic layer **34**, an auxiliary magnetization reversing layer **35** and a protective layer **36** in this order on a pinning thin film layer formed on a substrate constructing a magnetic head illustrated in the drawing, wherein two electrode layers **39**, **39** inserting the magnetoresistive multilayer film **C** therebetween with a space corresponding the track width TW, and two magnetic layers **40**, **40** that serve for allowing magnetization of the free ferromagnetic layer to be a single magnetic domain along X direction (the direction denoted by an arrow **a** in Fig. 3) are provided at both sides of the magnetoresistive multilayer film **C**.

In the construction described above, the directions of magnetization of free ferromagnetic layer **34** and magnetization of the pinned ferromagnetic layer **32** can be orthogonally aligned with each other with an angle of approximately 90° by allowing the former to direct along the direction of the arrow **a** in Fig. 3 and the latter to direct along the Z-direction.

The magnetoresistive multilayer film **C** with the construction shown in Fig. 3 is produced by the steps comprising: placing a non-magnetic ceramic substrate made of, for example, Al₂O₃ - TiC (Altic) in the chamber of a high frequency magnetron sputtering apparatus or an ion beam sputtering apparatus; replacing the atmosphere in the chamber with an inert gas such as Ar; and forming the layers in the required order. Targets required in forming the layers are, for example, α-Fe₂O₃ target, Ni-Fe target and Cu target.

The process for producing the magnetoresistive multilayer film **A** in Fig. 3 comprises: forming a pinning thin film layer **31** comprising α-Fe₂O₃ by sputtering on a substrate while impressing a magnetic field along the Z direction in Fig. 1 in an reduced pressure of Ar of 3 mTorr or less; forming two ferromagnetic layers **32** and **34** with a non magnetic layer **33** inserted therebetween; and laminating an auxiliary magnetization reversing layer **35** and a protective layer **36** in this order. Then, the laminated layers are processed to form a magnetoresistive multilayer film C by removing the layers except the portion corresponding to the track width by a photolithographic process and ion milling. After forming the magnetoresistive multilayer film C, two magnetic layers **40** and **40**, and two electrode layers **39** and **39** are formed so that the laminated member is inserted between the layers.

Subsequently, the direction of magnetization of the pinned ferromagnetic layer **32** is pinned to fix the direction of magnetization by applying a magnetic field perpendicular to the drawing paper in Fig. 3 to magnetize the pinning thin film layer **31**.

A magnetoresistive sensor with a construction shown in Fig. 3 can be obtained by the foregoing treatment, wherein the direction of magnetization of the pinned ferromagnetic layer **32** and the direction of magnetization of the free ferromagnetic layer **34** are orthogonally aligned with each other with an angle of 90°. However, magnetization as described above is not necessary when the pinning thin film layer **31** is produced using ferromagnetic materials such as Fe-Mn, Pt-Mn and Ir-Mn, instead, the direction of magnetization of the pinned ferromagnetic layer **32** is pinned by an exchange coupling.

As shown in Fig. 4, the auxiliary magnetization reversing layer **15** in the magnetoresistive multilayer film **A** in Fig. 1 may be provided on the substrate **10**, followed by providing a free ferromagnetic layer **14** thereon in addition to providing a pinned ferromagnetic layer **12** via a non-magnetic layer **13** in the present invention. An underlying layer may be also provided between the substrate **10** and auxiliary magnetization reversing layer **15**, if necessary, to align the crystal orientation of the auxiliary magnetization reversing layer **15**.

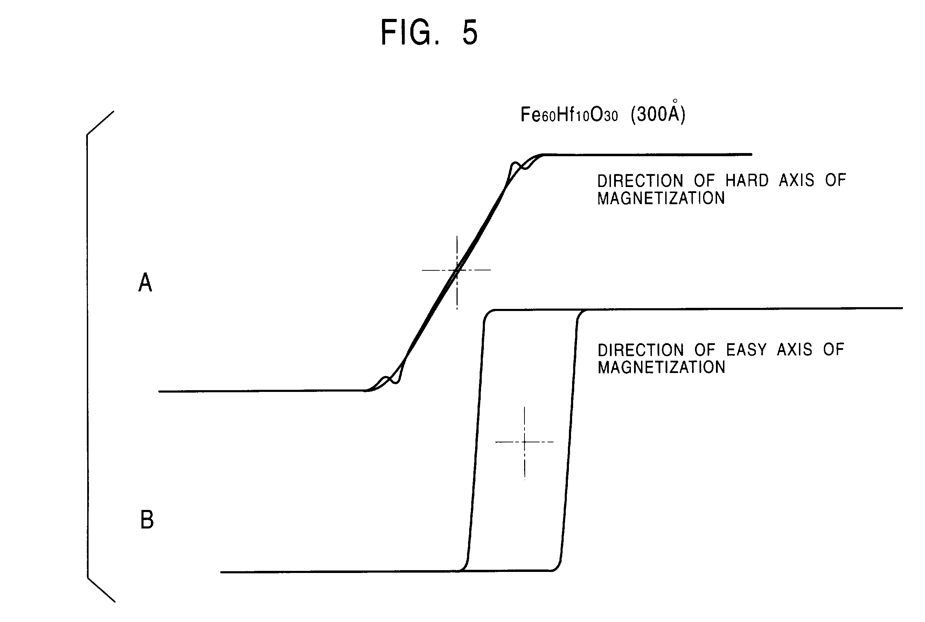

Fig. 5A and 5B show M-H curves when a soft magnetic film with a composition of Fe₆₀Hf₁₀O₃₀ is used for the auxiliary magnetization reversing layer with a construction shown in Fig. 1. This auxiliary magnetization reversing layer is formed on a substrate of Si covered with a protective layer of Al₂O₃ with a thickness of 300 Å. Fig. 5A and 5B correspond to M-H curves along the hard axis of magnetization and easy axis of magnetization, respectively. The soft magnetic film of this composition exhibits an excellent M-H curve as a soft magnetic film.

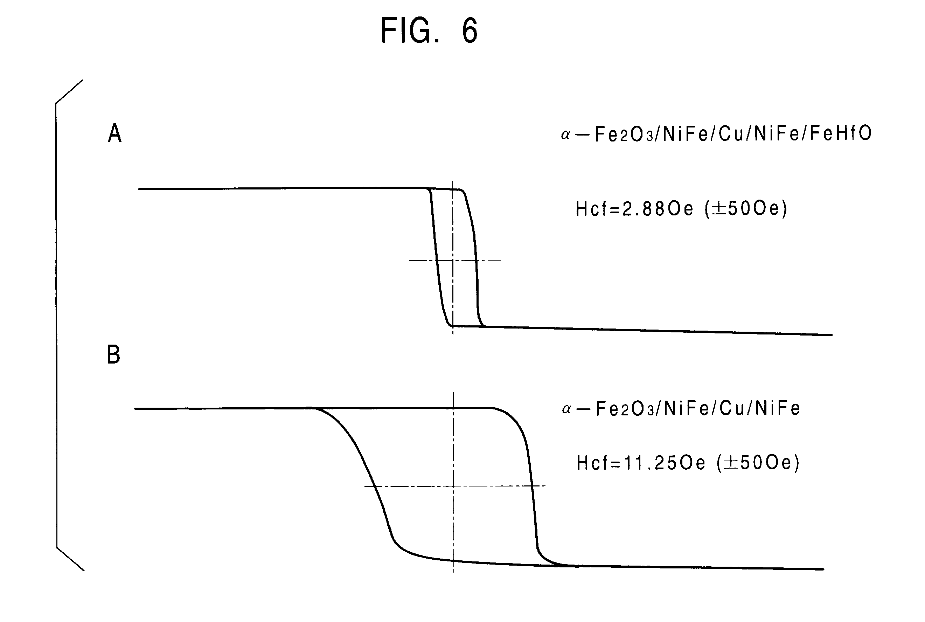

Fig. 6A shows a R-H curve of the free ferromagnetic layer having a laminated construction of α-Fe₂O₃ (coercive force increasing layer and pinning thiln film layer, thickness 1000 Å) / NiFe layer (pinned ferromagnetic layer, thickness 58 Å) / Cu layer (non-magnetic layer, thickness 22 Å) / NiFe layer (free ferromagnetic layer, thickness 87 Å) / Fe₆₀Hf₁₀O₃₀ (auxiliary magnetization reversing layer, thickness 300 Å) on a substrate of Si substrate / Al₂O₃ layer, while Fig. 6B shows a R-H curve of the free ferromagnetic layer having a construction in which the auxiliary magnetization reversing layer is omitted in the foregoing laminated structure.

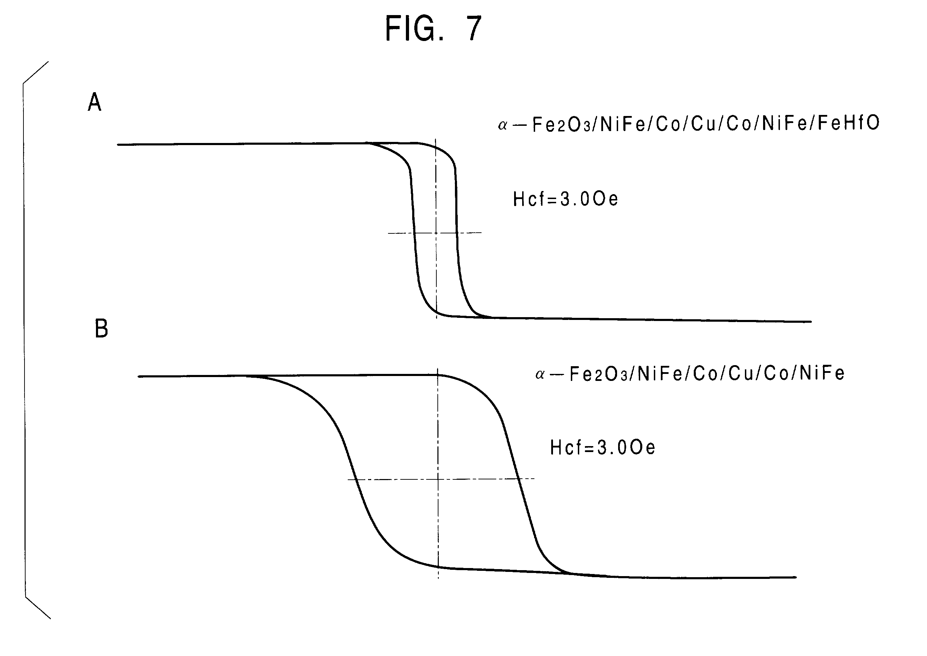

Fig. 7A shows a R-H curve of the free ferromagnetic layer having a laminated construction of α-Fe₂O₃ (1000 Å) / NiFe layer (48 Å) / Co layer (10 Å) / Cu layer (22 Å) / Co layer (10 Å) / NiFe layer (77 Å) / Fe₆₀Hf₁₀O₃₀ (300 Å) on a substrate of Si substrate / Al₂O₃ layer, while Fig. 7B shows a R-H curve of the free ferromagnetic layer having a construction in which the auxiliary magnetization reversing layer is omitted in the foregoing laminated structure. Hcf in the figure denotes the coercive force of the free ferromagnetic layer.

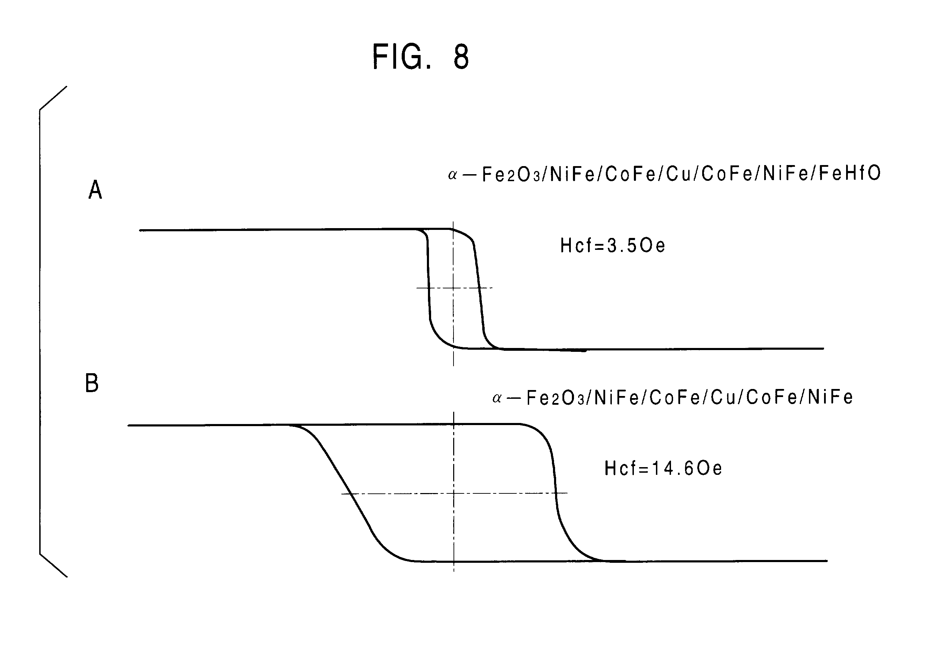

Fig. 8A shows a R-H curve of the free ferromagnetic layer having a laminated construction of α-Fe₂O₃ (1000 Å) / NiFe layer (48 Å) / CoFe layer (10 Å) / Cu layer (22 Å) / CoFe layer (10 Å) / NiFe layer (77 Å) / Fe₆₀Hf₁₀O₃₀ (300 Å) on a substrate of Si substrate / Al₂O₃ layer, while Fig. 8B shows a R-H curve of the free ferromagnetic layer having a construction in which the auxiliary magnetization reversing layer is omitted in the foregoing laminated structure. Hcf in the figure also denotes the coercive force of the free ferromagnetic layer as in Fig. 6.

It is made clear from the results in Fig. 6, Fig. 7 and Fig. 8 that coercive force (Hcf) becomes smaller in each laminated structure in each sample provided with the auxiliary magnetization reversing layer than the samples without this layer. Accordingly, inversion of magnetization is made easy by a small external magnetic field in the magnetoresistive multilayer film provided with an auxiliary magnetization reversing layer, sensitively responding to the external magnetic field.

## Claims

1. A magnetoresistive element comprising at least one pinned ferromagnetic layer in which inversion of magnetization is pinned, at least one free ferromagnetic layer in which magnetization is freely reversed in response to external magnetic field, and an auxiliary magnetization reversing layer assisting inversion of magnetization of the free ferromagnetic layer in adjoining relation or closely spaced relation to the free ferromagnetic layer and having a soft magnetic characteristic.

2. A magnetoresistive element according to Claim 1, wherein said auxiliary magnetization reversing layer mainly comprises a fine crystalline phase principally composed of bcc Fe structure and an amorphous phase containing an element M comprising one or a plurality of elements selected from Ti, Zr, Hf, V, Nb, Ta, W and rare earth elements, and O (oxygen).

3. A magnetoresistive effect element according to Claim 1, wherein said auxiliary magnetization reversing layer mainly comprises a fine crystalline phase principally composed of bcc Fe structure and a crystalline phase containing carbide or nitride of an element M comprising one or a plurality of elements selected from Ti, Zr, Hf, V, Nb, Ta, W and rare earth elements.

4. A magnetoresistive element according to Claiml,2 or 3, wherein said pinned ferromagnetic layer is provided in adjoining relation to an exchange coupling layer so that inversion of magnetization of pinned ferromagnetic layer is pinned in response to the magnetic exchange coupling due to said exchange coupling layer.

5. A magnetoresistive element according to Claim 4, wherein said exchange coupling layer is mainly composed of α-Fe₂O₃.

6. A magnetoresistive element according to Claim 4, wherein said exchange coupling layer is mainly composed of a X-Mn alloy (wherein X in the composition formula X-Mn denotes one or a plurality of elements selected from platinum group elements).

7. A magnetoresistive element according to any one of Claims 1-6,wherein the thickness of said auxiliary magnetization reversing layer is in the range of 50 to 300 Å.

8. A magnetoresistive element according to any one of Claims 1-7,wherein the specific resistivity of said auxiliary magnetization reversing layer is in the range of 200 to 2 × 10⁵ µΩcm.
